# EUROPEAN PATENT SPECIFICATION

(11) **EP 4 135 058 B1**
(45) Date of publication and mention of the grant of the patent: **24.09.2025**
(21) Application number: 22751633.3
(22) Date of filing: 21.02.2022
(51) Int. Cl.: H10N 30/30, G01L 1/16, G01L 5/167, H10D 30/43, H10D 48/50, H10D 62/10, H10D 64/27, B82Y 10/00, H10D 8/60, H10D 30/87

(54) **NANO-TUBE SEMICONDUCTOR DEVICE AND SHEAR FORCE SENSOR COMPRISING SAME**
NANOROHR-HALBLEITERVORRICHTUNG UND SCHERKRAFTSENSOR DAMIT
DISPOSITIF À SEMI-CONDUCTEUR À NANO-TUBE ET CAPTEUR DE FORCE DE CISAILLEMENT LE COMPRENANT

(30) Priority: 28.06.2021 KR 20210084163
(43) Date of publication of application: 15.02.2023
(73) Proprietor: Seoul National University R & DB Foundation, Seoul 08826 (KR); Foundation Of Soongsil University-Industry Cooperation, Seoul 06978 (KR)
(72) Inventor: YI, Gyuchul, Seoul 06317 (KR); OH, Hongseok, Seoul 08726 (KR)
(74) Representative: Isarpatent
(86) International application number: PCT/KR2022/002479
(87) International publication number: WO 2023/277296

(56) References cited:
- EP-A1- 2 336 742
- KR-A- 20060 127 105
- KR-A- 20080 009 729
- KR-A- 20180 016 795
- KR-A- 20180 089 791
- KR-B1- 101 355 930
- US-A1- 2009 179 523
- US-A1- 2011 006 286
- US-A1- 2011 084 345
- OH H ET AL: "Vertical ZnO Nanotube Transistor on a Graphene Film for Flexible Inorganic Electronics", SMALL, vol. 14, no. 17, 3 April 2018 (2018-04-03), Hoboken, USA, XP093147859, ISSN: 1613-6810, Retrieved from the Internet <URL:https://api.wiley.com/onlinelibrary/tdm/v1/articles/10.1002%2Fsmll.201800240> DOI: 10.1002/smll.201800240

## Description

### BACKGROUND OF THE INVENTION

### 1. Field

The present invention relates to a nanotube semiconductor device and a shear force sensor including the same.

### 2. Description of the Related Art

Recently, the pressure sensors using piezoelectric devices including a nanostructure such as nanorods or nanotubes have been developed. These pressure sensors include a plurality of nanostructures so that the sensor itself has a large volume. In addition, when measuring the pressure applied to a nanostructure, only a component in the vertical direction is measured, and it is difficult to measure a shear force which is horizontal to the substrate. In particular, since the existing shear force measurement is nothing more than a pressure sensor including a plurality of nanostructures is vertically set up to match the shear force direction, the measurement base thereof is the same as that of the pressure sensor.

### 3. Relevant prior art documents:

- D1: EP 2 336 742 A1
- D2: US 2011/006286 A1
- D3: US 2009/179523 A1
- D4: Non-patent Literature "Vertical ZnO Nanotube Transistor on a Graphene Film for Flexible Inorganic Electronics" (Oh H et. al.), SMALL 14 (2018), 1800240.

### SUMMARY OF THE INVENTION

The present invention is set out by the appended claims. According to the present invention, a nanotube semiconductor device and a shear force sensor including the same are provided.

A semiconductor device according to the present invention includes a substrate, a nanotube vertically disposed on the substrate, and at least one electrode disposed on a side surface of the nanotube, as defined by independent claim 1. The semiconductor device further comprises a lower electrode disposed under the nanotube, and an upper electrode on a top of the nanotube. The lower electrode is a source electrode, and the upper electrode is a drain electrode. When the shear force is applied, the semiconductor device is configured to sense a current change value from the source electrode and the drain electrode, as a current value flowing on the side surface of the nanotube is changed.

In addition, the nanotube may be a cylindrical structure in which diameter decreases as a distance from the substrate increases.

For example, the nanotube may have a diameter of 1 nm to 1000 nm, or a thickness of 1 nm to 10 nm, or a height of 10 nm to 100 *µ*m.

For example, an aspect ratio of the nanotube may be 1:1 to 1 1000.

In addition, at least one electrode may include a first electrode and a second electrode spaced apart from each other, wherein the first electrode may sense a change in charge distribution due to a first direction component of an applied shear force, and the second electrode may sense a change in charge distribution due to a second direction component of the applied shear force. The first direction may be parallel or anti-parallel to a direction from a center of the nanotube to a region in which the first electrode is arranged. The second direction may be parallel or anti-parallel to a direction from the center of the nanotube to a region in which the second electrode is arranged.

In addition, the first direction and the second direction may be perpendicular to each other, and a change in a two-dimensional direction charge distribution of the applied shear force may be sensed.

Furthermore, at least one electrode may be directly in contact with the nanotube, and may be used for sensing a voltage in an area in direct contact with the nanotube, and the sensed voltage may be used for shear force calculation.

Furthermore, the at least one electrode may include one electrode which is in contact with one area of the nanotube, and the one electrode may be used as a gate electrode to measure one direction component of the shear force. The one direction may be parallel or anti-parallel to a direction from a center of the nanotube to the one area.

In addition, an insulator may be further included between the at least one nanotube and the at least one electrode.

A shear force sensor according to an exemplary embodiment may comprise a semiconductor device as claimed and a processor for calculating shear force applied to the semiconductor device by using a change in charge distribution sensed through at least one electrode.

At least one nanotube may be vertically arranged on a substrate.

In addition, the nanotube may be a cylindrical structure in which a diameter decreases as a distance from a substrate increases.

For example, the nanotube may have a diameter of 1 nm to 1000 nm, or a thickness of 1 nm to 10 nm, or a height of 10 nm to 100 µm.

For example, an aspect ratio of the nanotube may be 1:1 to 1:1000.

In addition, the at least one electrode may include a first electrode and a second electrode spaced apart from each other, wherein the first electrode may sense a change in charge distribution due to a first direction component of the applied shear force, and the second electrode may sense a change in charge distribution due to a second direction component of the applied shear force. The first direction may be parallel or anti-parallel to a direction from a center of the nanotube to a region in which the first electrode is arranged. The second direction may be parallel or anti-parallel to a direction from the center of the nanotube to a region in which the second electrode is arranged.

The first and second directions may be perpendicular to each other, and a change in a two-dimensional direction charge distribution of the applied shear force may be sensed.

The semiconductor device according to an exemplary embodiment may measure shear force with a single nanotube.

The semiconductor device according to an exemplary embodiment may be applied to various device operation methods.

The shear force sensor including a semiconductor device according to an exemplary embodiment may provide a shear force sensor smaller in size than an existing sensor.

In the semiconductor device according to an exemplary embodiment, an aspect ratio may be adjusted, and a structure having a high aspect ratio may be sensitive to shear force, thereby being used for a high-sensitivity shear force sensor.

The shear force sensor including the semiconductor device according to the exemplary embodiment may precisely measure the direction of the shear force by including electrodes in several directions.

### BRIEF DESCRIPTION OF THE DRAWINGS

FIG. 1A is a cross-sectional view of a semiconductor device according to an exemplary embodiment that is not part of the present invention.
FIG. 1B is a cross-sectional view illustrating that shear force is applied in a direction of an arrow to a semiconductor device according to the exemplary embodiment that is not part of the present invention.
FIG. 2 is a plane view observed from a top of a semiconductor device according to the exemplary embodiment that is not part of the present invention.
FIG. 3A to FIG. 3E are plane views of shapes of several electrodes arranged in a semiconductor device according to another exemplary embodiment that is not part of the present invention.
FIG. 4 is a block diagram illustrating a shear force sensor according to an exemplary embodiment that is not part of the present invention.
FIG. 5A is a diagram illustrating a structure wherein a semiconductor device according to an exemplary embodiment that is not part of the present invention is composed of a Schottky diode.
FIG. 5B is a diagram illustrating a structure wherein a semiconductor device according to an exemplary embodiment is composed of a Schottky transistor.
FIG. 5C is a diagram illustrating a structure wherein a semiconductor device according to another exemplary embodiment is composed of a metal insulator semiconductor (MIS) transistor.

### DETAILED DESCRIPTION OF THE INVENTION

Hereinafter, we shall refer to the attached drawings to explain the embodiments in detail. The described embodiments are merely examples, and various modifications may be derived from these embodiments. In the following drawings, the same reference numbers refer to the same component, and the size of each component in the drawing may be exaggerated for clarity and convenience of the description.

Below, what is listed as "an upper side" or "on" may include a component arranged on an upper side by non-contact as well as a component directly arranged on an upper side by contact. Similarly, what is listed below "a lower side" or "below" may include a component arranged on a lower side by non-contact as well as a component directly arranged on a lower side by contact.

The expression of a singular type includes a plurality of components, unless it clearly means otherwise in context. Also, when a part "includes" a component, it means that other components may be further included, rather than excluding other components, unless there is a particular opposite description.

The use of the terminology, "said" and the similar indication terms may be applied to both of a singular type and a multiple type.

The meaning of "connection" may include optical connections, electrical connections and the like as well as physical connection.

In addition, the use of all exemplary terms (e.g., etc.) is described simply to elaborate on technological concepts, and the scope of rights is not limited by these terms unless they are limited by the claims.

The terms, "a first and a second" may be used to describe various components, but the components should not be limited by the terms. The terms are used only for the purpose of distinguishing one component from another.

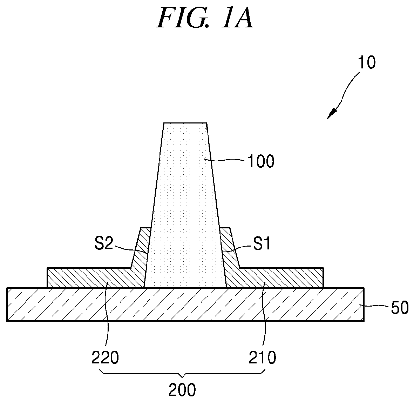

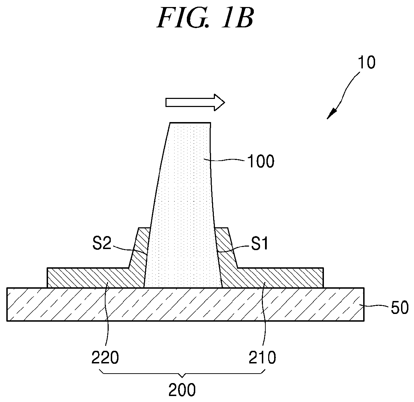

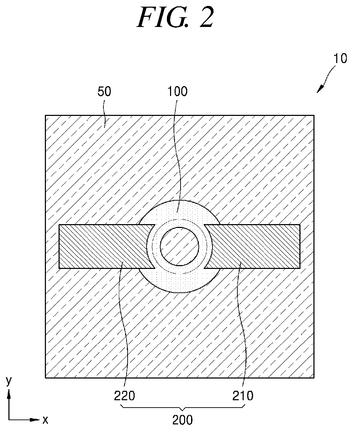

FIG. 1A shows a cross-sectional view of a semiconductor device according to an exemplary embodiment that is not part of the present invention, and FIG. 1B shows a cross-sectional view in which a shear force is applied to a semiconductor device according to the exemplary embodiment that is not part of the present invention. FIG. 2 is a plane view observed from the top of the semiconductor device according to the exemplary embodiment that is not part of the present invention.

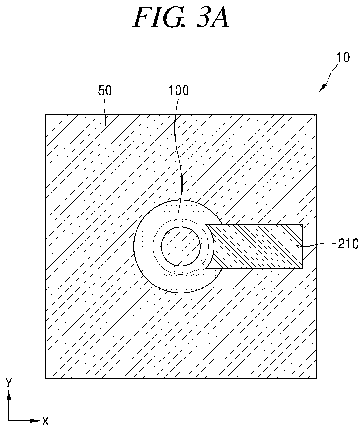

Referring to FIG. 1A, FIG. 1B, and FIG. 2, the semiconductor device 10 according to an exemplary embodiment may include a substrate 50, a nanotube 100 disposed on the substrate 50, and at least one electrode 200 disposed on a side surface of the nanotube 100. The nanotube 100 disposed on the substrate 50 may be vertically disposed on the substrate 50, and when a shear force horizontal to the substrate 50 is applied to the nanotube 100, the nanotube 100 may have an elastic force for being to be curved or bent. When the nanotube 100 is curved or bent by shear force applied to the nanotube 100, a change in a charge distribution in the nanotube 100 may be made by a piezoelectric effect and/or a flexoelectric effect, and at least one electrode 200 of the semiconductor device 10 may sense the change in the charge distribution. The direction and size of the shear force may be measured as the charge distribution change is sensed, and the semiconductor device 10 may be used as the shear force sensor. As described in the following paragraphs in detail with referring to FIG. 3A to FIG. 3E, by arranging a plurality of electrodes 200 at predetermined intervals such as a predetermined angle 90° or 180°, and in particular, by arranging a plurality of electrodes 200 at equally divided angles such as 45° (8 electrodes), 60° (6 electrodes), 90° (4 electrodes), or 180° (2 electrodes), the direction of the shear force may be sensed more accurately by the tensor calculation based on the angular distribution of the charge distribution.

The substrate 50 may be one of various substrates such as a single crystal substrate, a two-dimensional material substrate, and the like. Furthermore, the substrate 50 may be a flexible substrate and/or a transparent substrate. For example, if the nanotube 100 is disposed on a flexible substrate, the semiconductor device 10 may be used as a flexible device, and if the semiconductor device 10 is disposed on the transparent substrate, the semiconductor device 10 may be used as a transparent device. The substrate 50 may include a material having a crystallographically monocrystalline phase, such as silicon, sapphire, or gallium nitride and the like. However, the substrate is not limited to those materials, and amorphous and/or polycrystalline nanomaterials may be used. If the semiconductor device 10 includes a single crystal substrate including a material having a single crystal phase, it is possible to process the nanotube 100 by using an epitaxial growth creating a single crystal. As the material having a single crystal phase has a very remarkable piezoelectric effect and an excellent flexoelectric effect, the reaction sensitivity to shear force or the like may be higher. Therefore, it is desirable that the semiconductor device 10 measuring shear force includes a single crystal substrate.

The nanotube 100 disposed on the substrate 50 may have a nano-size and a junction size between the substrate 50 and the nanotube 100 may also have a nano-size. The substrate 50 may be a polycrystal substrate, a two-dimensional nanomaterial substrate and so on in addition to a single crystal substrate. In particular, when a two-dimensional nanomaterial is used as a substrate 50, the semiconductor device 10 may be mechanically peeled off and be transferred to any other substrate (plastic, glass, etc.), thereby being used for a flexible device and/or a transparent device. The substrate 50 may be removed after forming the semiconductor device 10.

The nanotube 100 may be disposed on the substrate 50 and may be disposed vertically on the substrate 50. The cross section of the small length among the aspect ratio of the nanotube100 is arranged to be in contact with the substrate 50, and the cross section of the long length may be arranged perpendicularly to the substrate 50. The nanotube 100 may be a cylindrical structure in which diameter decreases as a distance from the substrate 50 increases, and may be a cylindrical structure in which diameter is constantly maintained. However, as the diameter is not limited to this and as a distance from the substrate 50 increases, the diameter may be constant or increase, or increase and decrease may be repeated. The nanotube 100 may have a diameter of approximately 1 nm to 1000 nm, and/or a thickness of approximately 1 nm to 10 nm, and/or a height of approximately 10 nm to 100 *µ*m. The nanotube 100 may have an aspect ratio of 1:1 to 1:10000, and preferably has an aspect ratio of 1:1 to 1:100. As the aspect ratio of the nanotube 100 of the semiconductor device 10 increases, the deformation of the nanotube 100 may increase even by small shearing force. Thus, the semiconductor device 10 may have high sensitivity. Also, if the semiconductor device 10 includes a nanotube 100 having a large aspect ratio, the semiconductor device 10 may be used as a shear force sensor of high-sensitivity.

Only one singular nanotube 100 may be arranged, and a plurality of nanotubes may be arranged. The size and direction of the shear force may be measured even if a singular nanotube 100 is arranged, thus, the size of the semiconductor device 10 itself or size of the shear force sensor including the semiconductor device 10 may be small to about the nano size. If a plurality of the nanotubes 100 are arranged, the distance between adjacent nanotubes 100 may be from about 10 nm nm to 10 *µ*m. However, the nanotubes 100 may be arranged without being limited to the distance. Further, the distance between adjacent nanotubes 100 may be proportional to the diameter of the nanotube 100. For example, the distance between adjacent nanotubes 100 may be 20 nm if the diameter of the nanotube 100 is 10 nm, and if the diameter of the nanotube 100 is 100 nm, the distance between adjacent nanotubes 100 may be 200 nm. However, the embodiment is not limited to these numerical values and even if the diameter of the nanotube 100 is getting larger and larger, the distance between the adjacent nanotubes 100 may be constant.

The nanotube 100 may have the elastic force, and if the shear force horizontal to the substrate 50 is applied to the nanotube100, it may be curved and bent in a direction to which the shear force is applied. The nanotube 100 may include a material having a high piezoelectric effect and/or flexoelectric effect according to a shape deformation caused by curve or bending. If the nanotube100 is curved or bent by the applied shear force, a charge distribution in the nanotube 100 may be changed. Asymmetric charge distribution may occur due to these charge distribution changes, which may be generated due to piezoelectric effect and/or flexoelectric effect. The asymmetric charge distribution may be determined by the size and direction of the applied shear force applied. According to FIG. 1B, the nanotube 100 may be curved or bent along the direction of the shear force (in the arrow direction), in which case the right and left sections of the shear force may have different charges.

At least one electrode 200 of the semiconductor device according to an exemplary embodiment may be disposed on the side surface of the nanotube 100, and may be disposed in a direct contact manner. In case of the plurality of the electrodes 200, each of the electrodes 200 may be arranged so that they may be separated from each other. The electrode 200 may sense the change in a charge distribution of the nanotube 100 which is curved or bent by application of the shear force. For example, if the first electrode 210 is disposed on a first side surface S1 of the nanotube 100, the electrode 210 may sense the shear force in a direction from the center of the nanotube 100 to the first side surface S1 and in an anti-parallel direction (or 180 degree rotational direction) with respect to the direction. The size of the shear force may be sensed by measuring a voltage change or a current change and etc. according to a change in the charge distribution. For example, if the shear force applied to the nanotube 100 has a positive component for a direction to the first side surface S1 based on the center of the nanotube 100, the voltage or the current of the first electrode 210 may increase or decrease, and if the shear force applied to the nanotube 100 has a positive component for an anti-parallel direction to the direction, the voltage or current of the first electrode 210 may decrease or increase.

According to an exemplary embodiment, a plurality of electrodes 200 may be arranged on different side surfaces of the nanotube 100. For example, the first electrode 210 and the second electrode 220 may be arranged on the same straight line, as illustrated in FIG. 1B. In this case, the first electrode 210 and the second electrode 220 may be arranged so that a rotation symmetry may be formed based on the center of the nanotube 100 while forming 180 degree between them. If the first electrode 210 is arranged in the first side surface S1 of the nanotube 100, it may sense a shear force of a direction from the center of the nanotube 200 to the first side surface S1 and an anti-parallel direction with respect to the direction. Here, the anti-parallel direction may be a second side surface S2 direction in which a second electrode 220 is arranged based on the center of the nanotube 100. The second electrode 220 may sense the shear force of the above two directions. In the above example, the semiconductor device 10 may decompose a direction of a shear force one-dimensionally, such as a semiconductor device 10 wherein a first electrode 210 is arranged in contact with the nanotube 100 or a semiconductor device 10 wherein a second electrode 220 is arranged in contact with the nanotube 100. However, the example may have a resolution higher than that of a configuration wherein a singular electrode 200 is disposed. That is, if the first electrode 210 and the second electrode 220 are disposed as illustrated in FIG. 1B, the shear force of the directions which are anti-parallel to each other may be precisely analyzed.

The first electrode 210 and the second electrode 220 may not be disposed on the same straight line. For example, the first electrode 210 and the second electrode 220 may be perpendicularly disposed on a plane of the substrate 50. If the first electrode 210 is arranged according to the x direction and the second electrode 220 is arranged according to the y direction, the first electrode 210 may sense the x direction component or the -x direction component of the shear force. The second electrode 220 may sense the y direction component or the -y direction component. In other words, when the first electrode 210 and the second electrode 220 of the semiconductor device 10 are not arranged on the same straight line, the semiconductor device 10 may decompose the direction of the shear force in a two-dimensional manner. The shear force direction in two dimension may be included in a direction horizontal to the substrate 50. In order for the semiconductor device 10 to two-dimensionally decompose the direction of the shear force, the first electrode 210 and the second electrode 220 need not be perpendicular. For example, the first electrode 210 and the second electrode 220 may be arranged while forming 45 degrees between them based on the plane view observed from a top side of the semiconductor device 10. At this time, the first electrode 210 may sense the x direction component of the shear force, and the second electrode 220 may sense the component of the direction forming 45 degree for the x direction of the shear force. The direction of the shear force may be decomposed in a two-dimensional manner by setting the above two directions as a basis.

Two or more electrodes 200 may be arranged in the semiconductor device 10 according to an exemplary embodiment, and the directional resolution of the shear force may be further increased as the number of arranged electrodes 200 increases. That is, the two-dimensional direction of the shear force may be more precisely analyzed and measured.

A width of the electrode 200 of the semiconductor device 10 according to an exemplary embodiment may be equal to or less than the longest diameter of the nanotube 100. For example, the width of the electrode 200 may be from 1 nm to 1000 nm. The direction of the shear force applied to the nanotube 100 may be measured more precisely as the width of the electrode 200 is getting smaller and smaller. For example, if the width of the electrode 200 is small, a larger number of electrodes 200 may be arranged on the nanotube 100, so that the direction of the shear force may be measured more precisely. In another aspect, as the width of the electrode 200 is getting smaller, the direction of the shear force may be measured more precisely as the shear force having a minute angle difference may be distinguished or analyzed.

The first electrode 210 of the semiconductor device 10 according to an exemplary embodiment may sense a change in the charge distribution of the nanotube 100 and may sense a change in the charge distribution due to a first direction component of the applied shear force. Here, the first direction may be in a direction from a center of the nanotube 100 to the first side surface S1 of the nanotube 100 in which the first electrode 210 is arranged, or in an anti-parallel direction with respect to the direction. The first electrode 210 may sense voltage or the current and the like of the first side surface S1 of the nanotube 100. For example, if the shear force includes a first direction component, the voltage of the first electrode 210 generated when the shear force is applied may be higher than that of a case where the shear force is not applied. This is because, as the nanotube 100 to which a shear force is applied is curved or bent, an asymmetric charge distribution is generated due to piezoelectric and/or transformation effects. As one or more electrode 200 senses voltage or the current change of the side surface of the nanotube 100 to which the electrode 200 is adhered, the direction and the size of the applied shear force may be sensed.

Referring to FIG. 1B, the shear force may be applied to the nanotube 100 in a first direction (in the arrow direction), where the first direction may be a direction from the center of the nanotube 100 to the first electrode 210. As the charge distribution within the nanotube 100 which is curved or bent by the shear force is changed, an increased voltage may be sensed in the first electrode 210 as compared with the case where the nanotube 100 is in a normal state. Also, a reduced voltage as compared with a case where the nanotube 100 is in a normal state may be sensed in the second electrode 220. Each changed voltage may be sensed by the first electrode 210 and/or the second electrode 220 , and through this, the magnitude of the first direction component of the shear force may also be sensed.

FIG. 3A to FIG. 3E are the plane views illustrating the shapes of a plurality of electrodes 200 arranged in a semiconductor device 10 according to another exemplary embodiment that is not part of the present invention.

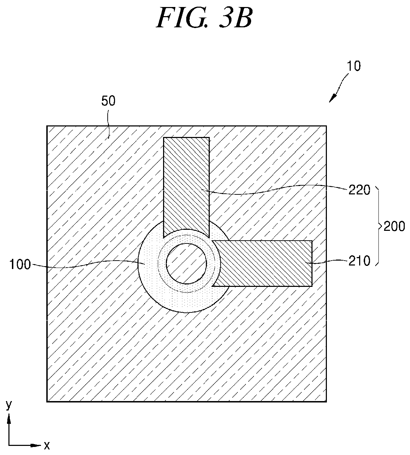

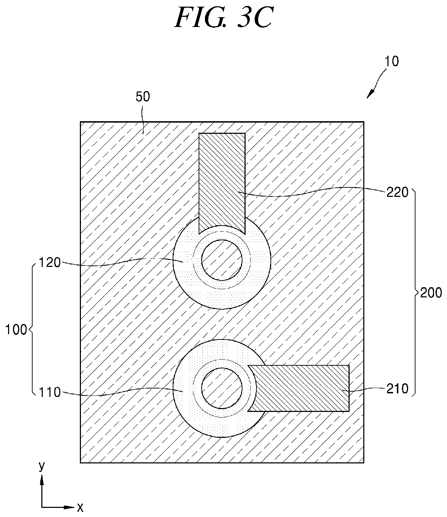

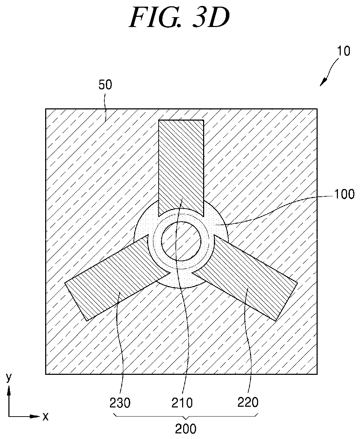

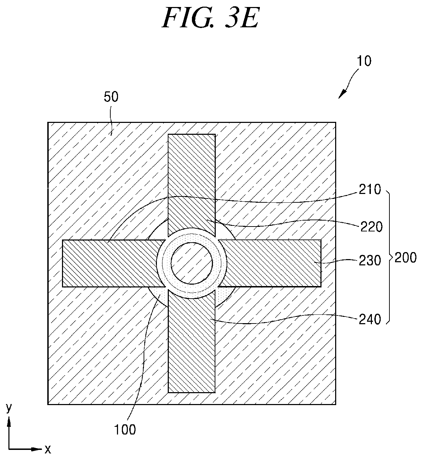

Referring to FIG. 3A, the semiconductor device 10 may include a nanotube 100 and a first electrode 210. The first electrode 210 may be said to have been arranged toward the x-axis, and the first electrode 210 may sense a change in the charge distribution for the x-axis direction component of the applied shear force. The semiconductor device 10 according to the illustration of FIG. 3A may be useful when measuring only one direction of the applied shear force. When compared with a semiconductor device 10 of FIG. 2, the semiconductor device 10 in FIG. 2 may more precisely measure the x-axis direction of the shear force than the semiconductor device 10 in FIG. 3. In other words, the semiconductor device 10 in FIG. 2 has a higher resolution of the x-axis direction of the shear force than the semiconductor device 10 in FIG. 3A.

Referring to FIG. 3B, the semiconductor device 10 includes a nanotube 100, a first electrode 210 and a second electrode 220. Two electrodes 210, 220 may be said to have been perpendicularly arranged based on a center of the nanotube 100, and the electrode 210 may sense a change in charge distribution for the x-axis direction component of the shear force, and the other electrode 220 may sense a change in charge distribution for the y-axis direction component of the shear force. Therefore, the semiconductor device 10 of FIG. 3B may decompose the direction of the shear force into two dimension, thereby sensing the direction of the shear force horizontal to the substrate 50.

Referring to FIG. 3C, the semiconductor device 10 includes a first nanotube 110, a second nanotube 120, a first electrode 210 and a second electrode 220. The diameter, the height, and the thickness of the first and the second nanotubes 110, 120 may be almost identical. The first electrode 210 arranged on the first nanotube 110 may sense a change in charge distribution for an x-axis component of the shear force, and the second electrode 220 arranged on the second nanotube 120 may sense a change in charge distribution for a y-axis component of the shear force. At this time, the distance between the first and second nanotubes 110, 120 is sufficiently adjacent, and the shear force received by the two nanotubes 110, 120 may be almost the same. Here, in connection with the specific meaning of a sufficiently adjacent distance, the distance between the two nanotubes 110, 120 may be equivalent to 0.5 to 2 times of the diameter of the first nanotube 110. In this case, as in the semiconductor device 10 of FIG. 3B, the direction of the shear force may be decomposed into two dimension, so that the direction of the shear force horizontal to the substrate 50 may be sensed.

Referring to FIG. 3D, the semiconductor device 10 may include a nanotube 100 and three electrodes 210, 220, 230. The three electrodes 210, 220, 230 may form 120 degree around a center of the nanotube 100. Each electrode 200 may sense a directional component of a shear force where the each electrode 200 is in contact with and arranged. Here, the direction where each electrode 200 is in contact with and arranged may mean a side direction of the nanotube 100 with which the each electrode 200 is in contact around the nanotube 100. As the semiconductor device 10 in FIG 3D includes more electrodes 200 than the semiconductor device 10 in FIG. 3B, the direction of the shear force may be measured more precisely, and as a result, the resolution of the shear force direction is higher.

Referring to FIG. 3E, the semiconductor device 10 may include a nanotube 100 and four electrodes 210, 220, 230, 240. The four electrodes 210, 220, 230, 240 may be arranged so that they may be separated by 90 degree from each other based on a center of the nanotube 100. Two electrodes 210, 230 arranged along the x-axis direction may sense the charge distribution for the x-direction component of the shear force, and two electrodes 220, 240 arranged along the y-axis direction may sense the charge distribution for the y-direction component of the shear force. As the semiconductor device 10 in FIG. 3E includes more electrodes 200 than the semiconductor device 10 of FIG. 3B, the direction of the shear force may be measured more precisely, and as a result, the semiconductor device 10 in FIG. 3E may have a higher shear force direction resolution.

The semiconductor device 10 according to an exemplary embodiment may be a component of a shear force sensor A1.

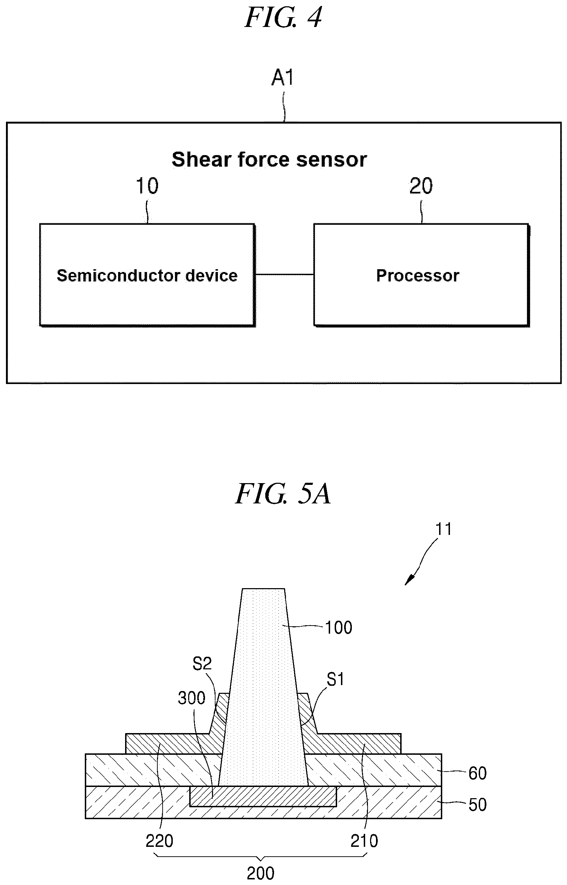

FIG. 4 is a block diagram illustrating a shear force sensor A1 according to an embodiment that is not part of the present invention. As illustrated in FIG. 4, a processor 20 may be further included. The processor 20 may calculate a shear force applied to the semiconductor device 10 based on a voltage value or a current value sensed by at least one electrode 200 according to a change in charge distribution. The processor 20 may be disposed inside the substrate 50 and may be extended to the electrode 200 and be disposed outside the substrate 50. Alternatively, the processor 20 may be not directly connected to the semiconductor device 10, and may calculate a shear force by receiving only the sensed voltage value or the sensed current value.

The semiconductor device 10 according to an exemplary embodiment may sense a change in charge distribution according to a shear force applied to the semiconductor device 10 or the nanotube 100, and may calculate a direction and/or a magnitude of the applied shear force by inversely calculating the sensed change of charge distribution. Therefore, the semiconductor device 10 may be used as a shear force sensor A1 for measuring shear force. The semiconductor device 10 may also implement a shear force sensor A1 by using a single nanotube 100 to provide a very small size, for example, a shear force sensor A1 of a nano size. In particular, the nanotube 100 may have various aspect ratios, so that it may provide a high-sensitivity shear force sensor A1 as needed. The semiconductor device 10 according to an exemplary embodiment described above may be used for a flexible device and/or a transparent device. Furthermore, the semiconductor device 10 may be manufactured in a large area using a deposition process. For example, the deposition process may be a chemical vapor deposition method. When a semiconductor device 10 according to the above-described exemplary embodiment is used for a shear force sensor A1, the semiconductor device 10 may detect motions such as a user's touch, movement, respiration, etc., so that it may be used for a tactile sensor, a touch interface, a robot, a medical device, a smart device, a wearable device, etc.

FIG. 5A to FIG. 5C are diagrams illustrating the cases in which semiconductor devices 11, 12, 13 according to an exemplary embodiment are used according to various operating methods.

Referring to FIG. 5A, the semiconductor device 11 according to an exemplary embodiment that is not part of the present invention may be used as a diode. A third electrode 300 may be attached under the nanotube 100 of the semiconductor device 11, and the current flowing between one or more electrode 200 (hereinafter, the side electrode) arranged on a side surface of the nanotube 100 and the third electrode 300 may be measured. The side electrode 200 may be arranged while directly contacting with a lateral side of the nanotube 100. At this time, the third electrode 300 may serve as a source electrode, and the side electrode 200 may serve as a drain electrode. The third electrode 300 and the side electrode 200 may be disposed to be spaced apart from each other. The third electrode 300 may be arranged under the nanotube 100 and may be embedded into the substrate 50. As the length of the third electrode 300 is smaller than the diameter of the nanotube 100, the third electrode 300 and the side electrode 200 may be arranged to be separated from each other. But, the length of third electrode 300 is not limited to this, and the length of the third electrode 300 may be greater than the diameter of the nanotube 100, and in this case, a dielectric layer 60 may be disposed on the substrate 50, and the side electrode 200 may be disposed on the dielectric layer 60. Thus, the third electrode 300 and the side electrode 200 may be separated. The semiconductor device 11 may operate in the form of a Schottky diode as a Schottky barrier is formed on an interface between the side electrode 200 and the nanotube 100. The semiconductor device 11 may sense the change of the current flowing between the side electrode 200 and the third electrode 300, and through this, a shear force may be calculated. For example, if it is needed to sense a first direction component of shear force, a current change value of a side electrode 200 arranged in a first direction based on the center of the nanotube 100 or an anti-parallel direction to the direction may be sensed. The first electrode 210 arranged in the first direction based on the nanotube center may sense the current change value of the first side surface S1 of the nanotube 100. If the semiconductor device 11 according to an exemplary embodiment constitutes a shear force sensor A1 together with the processor 20, the processor 20 may calculate shear force applied to the semiconductor device 11 through a change value of current. In addition, in the previous embodiment, an example wherein the semiconductor device 11 includes one side electrode 200 is described, but embodiments are not limited to this, and may include a plurality of side electrodes 200. Each of the plurality of side electrodes 200 may serve as of a drain electrode. For example, a second electrode 220 disposed in a second direction based on the center of the nanotube 100 is disposed in contact with a second side surface S2 of the nanotube 100 and may sense a current change value of the second side surface S2.

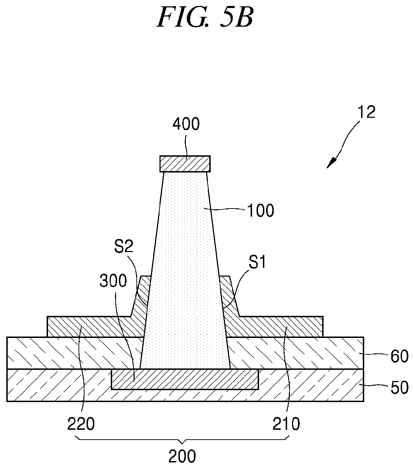

Referring to FIG. 5B, the semiconductor device 12 according to an exemplary embodiment may be used as a transistor. A third electrode 300 is attached under the nanotube 100 of the semiconductor device 12, and a fourth electrode 400 is attached to a top of the nanotube 100 of the semiconductor device 12. The side electrode 200 may be arranged while directly contacting a lateral side of the nanotube 100. Here, the third electrode 300 may operate as a source electrode, the fourth electrode 400 may operate as a drain electrode, and the side electrode 200 may operate as a gate electrode. The third electrode 300 and the side electrode 200 may be arranged to be separated from each other. The third electrode 300 is arranged under the nanotube 100, and may be embedded into the substrate 50. As the length of the third electrode 300 is smaller than the diameter of the nanotube 100, the third electrode 300 and side electrode 200 may be separated from each other. But, the length of third electrode 300 is not limited to this, and the length of the third electrode 300 may be greater than the diameter of the nanotube 100, and in this case, as a dielectric layer 60 may be disposed on the substrate 50, and the side electrode 200 may be disposed on the dielectric layer 60, the third electrode 300 and the side electrode 200 may be separated from each other. For example, if it is needed to sense a first direction component of shear force, a voltage of 0 V may be maintained in a side electrode 200 arranged in contact with a first direction or an anti-parallel direction to the first direction based on the center of the nanotube 100, and a negative voltage may be applied to a remaining side electrode 200 which does not need the measurement. The first electrode 210 arranged in the first direction based on the nanotube 100 center is arranged to contact to the first side surface S1 of the nanotube 100, and the current flow of the first side surface S1 may be controlled by the first electrode 210. When shear force is applied, the current value flowing in the first side surface S1 is changed, and such current change value may be sensed from the third electrode 300 and the fourth electrode 400. The semiconductor device 12 may be said to operate in the form of a Schottky transistor. When the semiconductor device 12 is a transistor type, a gate voltage may be applied to and/or adjusted to a side electrode 200 arranged in a specific direction to sense a change in a current flowing on a specific side of the nano device, thereby calculating the size of a specific direction component of a shear force. If the semiconductor device 12 according to an exemplary embodiment constitutes a shear force sensor A1 together with the processor 20, the processor 20 may calculate a specific direction component of the shear force applied to the semiconductor device 12 through a change value of current. The merit may exist that the semiconductor device 12 in the form of a Schottky transistor according to an exemplary embodiment may control the flow of current even if a small voltage is applied to the gate electrode. However, the semiconductor device 12 of a Schottky transistor type according to an exemplary embodiment is not limited to a normal on type as in the previous embodiment. In addition, in the previous embodiment, an example wherein the semiconductor device 12 includes one side electrode 200 is described, but it is not limited to this, and may include a plurality of side electrodes 200. Each of the plurality of side electrodes 200 may serve as a gate electrode. For example, a second electrode 220 disposed in a second direction based on the center of the nanotube 100 is disposed in contact with a second lateral side S2 of the nanotube 100, and the current flow of the second side surface may be adjusted by the second electrode 220. A gate voltage may be independently applied to each of the plurality of side electrodes 200, and a current flow may be controlled on a side surface with which each of the plurality of side electrodes 200 is in contact by the plurality of side electrodes 200.

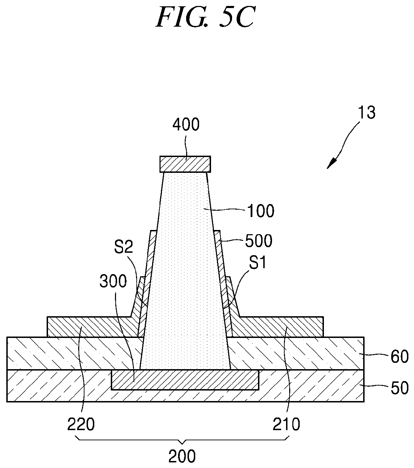

Referring to FIG. 5C, a semiconductor device 13 according to another exemplary embodiment further includes an insulator 500 between the side electrode 200 and the nanotube 100. The side electrode 200 is disposed in contact with the insulator 500, and not in direct contact with the nanotube 100. A third electrode 300 is attached under the nanotube 100 of the semiconductor device 13, and a fourth electrode 400 is attached to a top of the nanotube 100 of the semiconductor device 13. Here, the third electrode 300 may operate as a source electrode, the fourth electrode 400 may operate as a drain electrode, and the side electrode 200 may operate as a gate electrode. The third electrode 300 and the side electrode 200 may be arranged to be separated from each other. The third electrode 300 may be arranged under the nanotube 100, and may be embedded into the substrate 50. As the length of the third electrode 300 is smaller than the diameter of the nanotube 100, the third electrode 300 and side electrode 200 may be separated from each other. But, the length of third electrode is not limited to this, and the length of the third electrode 300 may be greater than the diameter of the nanotube 100, and in this case, a dielectric layer 60 may be disposed on the substrate 50, and the side electrode 200 may be disposed on the dielectric layer 60. For example, if a first direction component of shear force is to be sensed, a positive voltage may be applied to a side electrode 200 arranged in contact with a first direction or an anti-parallel direction to the first direction based on the center of the nanotube 100, and 0 V may be maintained at a remaining side electrode 200 which does not need the measurement. The first electrode 210 arranged in the first direction based on the center of the nanotube 100 is arranged in contact with the first side surface S1 of the nanotube 100, and the current flow of the first side surface S1 may be controlled by the first electrode 210. When shear force is applied, the current value flowing in the first side surface S1 is changed, and such current change value may be sensed from the third electrode 300 and the fourth electrode 400.

In this way, the semiconductor device 13 may operate in the form of a metal insulator semiconductor (MIS) transistor. When the semiconductor device 13 is a transistor type, a gate voltage may be applied to and/or adjusted to a side electrode 200 arranged in a specific direction to sense a change in a current flowing on a specific side of the nano device, thereby calculating a size of a specific direction component of shear force. If the semiconductor device 13 according to an exemplary embodiment constitutes a shear force sensor A1 with the processor 20, the processor 20 may calculate a specific direction component of the shear force applied to the semiconductor device 13 based on a change value of current. The semiconductor device 13 in the form of an MIS transistor according to an exemplary embodiment is not limited to a normal off type as in the previous example. In addition, in the previous embodiment, an example wherein the semiconductor device 13 includes one side electrode 200 is described, but the present invention is not limited to it, and may include a plurality of side electrodes 200. Each of the plurality of side electrodes 200 may serve as of the gate electrode. For example, a second electrode 220 disposed in a second direction based on the center of the nanotube 100 is disposed in contact with a second lateral side S2 of the nanotube 100, and the current flow of the second side surface may be adjusted by the second electrode 220. A gate voltage may be independently applied to each of the plurality of side electrodes 200, and a current flow may be controlled on a side surface with which each of the plurality of side electrodes 200 is in contact by the plurality of side electrodes 200.

The above-mentioned embodiments are only exemplary, and a person having ordinary knowledge in the related technology field will understand that various modifications may be made. The invention is defined by the appended claims.

As described in the present invention, as the nanotube oriented in a vertical direction on the substrate is arranged alone or in an array shape, it may be used as a shear force sensor and a semiconductor device.

### [Explanation of Numerical Symbols]

| | | | |
|---|---|---|---|
| 10, 11, 12, 13: | Semiconductor Device | | |
| 20: | Processor | 50: | Substrate |
| 60: | Dielectric layer | 100: | Nanotube |
| 200: | Electrode | 210: | First Electrode |
| 220: | Second Electrode | 300: | Third Electrode |
| 400: | Fourth Electrode | 500: | Insulator |
| A1: | Shear Force Sensor | | |

## Claims

1. A semiconductor device (12, 13) for measuring shear force, comprising:
a substrate (50);
a nanotube (100) vertically arranged on the substrate; and
at least one side electrode (200; 210, 220) arranged on at least one side surface of the nanotube,
**characterized in that**:
the semiconductor device further comprises a lower electrode (300) disposed under the nanotube, and an upper electrode (400) on a top of the nanotube,
the lower electrode (300) is a source electrode, and the upper electrode (400) is a drain electrode, and
when the shear force is applied, the semiconductor device is configured to sense a current change value from the source electrode (300) and the drain electrode (400), as a current value flowing on the side surface of the nanotube (100) is changed.

2. The semiconductor device for measuring shear force of claim 1, wherein the nanotube (100) is a cylindrical structure in which a diameter decreases as a distance from the substrate (50) increases.

3. The semiconductor device for measuring shear force of claim 1 or 2, wherein the nanotube (100) has a diameter of 1 nm to 1000 nm, or has a thickness of 1 nm to 10 nm, or has a height of 10 nm to 100 *µ*m, and
wherein an aspect ratio of the nanotube (100) is 1:1 to 1:1000.

4. The semiconductor device for measuring shear force of any of claims 1 to 3, wherein the at least one side electrode (200) includes a first electrode (210) and a second electrode (220) spaced apart from each other,
the first electrode (210) senses a change in charge distribution due to a first direction component of an applied shear force,
the second electrode (220) senses a change in charge distribution due to a second direction component of the applied shear force,
the first direction is parallel or anti-parallel to a direction from a center of the nanotube to a region in which the first electrode (210) is arranged, and
the second direction is parallel or anti-parallel to a direction from the center of the nanotube to a region in which the second electrode (220) is arranged.

5. The semiconductor device for measuring shear force of claim 4, wherein the first direction and the second direction are perpendicular to each other, and the semiconductor device is configured to two-dimensionally decompose a direction of the applied shear force.

6. The semiconductor device for measuring shear force of any preceding claim, wherein the at least one side electrode (200) is directly in contact with the nanotube (100), and is configured to sense a voltage in an area in direct contact with the nanotube (100).

7. The semiconductor device for measuring shear force of claim 1, wherein the at least one side electrode (200) includes one electrode (210, 220) which is in contact with one area of the nanotube,
the one electrode is a gate electrode to measure one direction component of the shear force, and
the one direction is parallel or anti-parallel to a direction from a center of the nanotube to the one area.

8. The semiconductor device for measuring shear force of claim 1, further comprising an insulator (500) between the at least one nanotube (100) and the at least one side electrode (200).

9. A shear force sensor (A1) comprising:
a semiconductor device (12, 13) according to any one of claims 1 to 8; and
a processor (20) for calculating a shear force applied to the semiconductor device by using a change in charge distribution sensed through the at least one side electrode,

## Patentansprüche

1. Halbleitervorrichtung (12, 13) zum Messen einer Scherkraft, umfassend:
ein Substrat (50);
eine Nanoröhre (100), die vertikal auf dem Substrat angeordnet ist; und
mindestens eine Seitenelektrode (200; 210, 220), die an mindestens einer Seitenfläche der Nanoröhre angeordnet ist,
**dadurch gekennzeichnet, dass**:
die Halbleitervorrichtung des Weiteren eine unter der Nanoröhre angeordnete untere Elektrode (300) und eine obere Elektrode (400) auf einer Oberseite der Nanoröhre umfasst,
die untere Elektrode (300) eine Source-Elektrode ist und die obere Elektrode (400) eine Drain-Elektrode ist, und,
wenn die Scherkraft angelegt wird, die Halbleitervorrichtung dazu eingerichtet ist, einen Stromänderungswert von der Source-Elektrode (300) und der Drain-Elektrode (400) abzufühlen, wenn sich ein an der Seitenfläche der Nanoröhre (100) fließender Stromwert ändert.

2. Halbleitervorrichtung zum Messen einer Scherkraft nach Anspruch 1, wobei die Nanoröhre (100) eine zylindrische Struktur ist, bei der ein Durchmesser mit zunehmender Entfernung von dem Substrat (50) kleiner wird.

3. Halbleitervorrichtung zum Messen einer Scherkraft nach Anspruch 1 oder 2, wobei die Nanoröhre (100) einen Durchmesser von 1 nm bis 1000 nm aufweist oder eine Dicke von 1 nm bis 10 nm aufweist oder eine Höhe von 10 nm bis 100 µm aufweist, und
wobei ein Seitenverhältnis der Nanoröhre (100) 1:1 bis 1: 1000 beträgt.

4. Halbleitervorrichtung zum Messen einer Scherkraft nach einem der Ansprüche 1 bis 3, wobei die mindestens eine Seitenelektrode (200) eine erste Elektrode (210) und eine zweite Elektrode (220) umfasst, die voneinander beabstandet sind,
die erste Elektrode (210) eine Änderung der Ladungsverteilung aufgrund einer ersten Richtungskomponente einer angelegten Scherkraft abfühlt,
die zweite Elektrode (220) eine Änderung der Ladungsverteilung aufgrund einer zweiten Richtungskomponente der angelegten Scherkraft abfühlt,
die erste Richtung parallel oder antiparallel zu einer Richtung von einer Mitte der Nanoröhre zu einer Region, in der die erste Elektrode (210) angeordnet ist, verläuft, und
die zweite Richtung parallel oder antiparallel zu einer Richtung von der Mitte der Nanoröhre zu einer Region, in der die zweite Elektrode (220) angeordnet ist, verläuft.

5. Halbleitervorrichtung zum Messen einer Scherkraft nach Anspruch 4, wobei die erste Richtung und die zweite Richtung senkrecht zueinander verlaufen, und die Halbleitervorrichtung dazu eingerichtet ist, eine Richtung der angelegten Scherkraft zweidimensional zu zerlegen.

6. Halbleitervorrichtung zum Messen einer Scherkraft nach einem der vorangehenden Ansprüche, wobei die mindestens eine Seitenelektrode (200) unmittelbar in Kontakt mit der Nanoröhre (100) ist und dazu eingerichtet ist, eine Spannung in einem Bereich in unmittelbarem Kontakt mit der Nanoröhre (100) abzufühlen.

7. Halbleitervorrichtung zum Messen einer Scherkraft nach Anspruch 1, wobei die mindestens eine Seitenelektrode (200) eine Elektrode (210, 220) umfasst, die mit einem Bereich der Nanoröhre in Kontakt steht,
die eine Elektrode eine Gate-Elektrode zum Messen einer Richtungskomponente der Scherkraft ist, und
die eine Richtung parallel oder antiparallel zu einer Richtung von einer Mitte der Nanoröhre zu dem einen Bereich verläuft.

8. Halbleitervorrichtung zum Messen einer Scherkraft nach Anspruch 1, des Weiteren umfassend einen Isolator (500) zwischen der mindestens einen Nanoröhre (100) und der mindestens einen Seitenelektrode (200).

9. Scherkraftsensor (A1), umfassend:
eine Halbleitervorrichtung (12, 13) nach einem der Ansprüche 1 bis 8; und
einen Prozessor (20) zum Berechnen einer an die Halbleitervorrichtung angelegten Scherkraft unter Verwendung einer durch die mindestens eine Seitenelektrode abgefühlten Änderung der Ladungsverteilung.

## Revendications

1. Dispositif à semi-conducteur (12, 13) pour mesurer une force de cisaillement, comprenant :
un substrat (50) ;
un nanotube (100) agencé verticalement sur le substrat ; et
au moins une électrode latérale (200 ; 210, 220) agencée sur au moins une surface latérale du nanotube,
**caractérisé en ce que**
le dispositif à semi-conducteur comprend en outre une électrode inférieure (300) disposée sous le nanotube, et une électrode supérieure (400) sur le haut du nanotube,
l'électrode inférieure (300) est une électrode source et l'électrode supérieure (400) est une électrode drain, et
lorsque la force de cisaillement est appliquée, le dispositif à semi-conducteur est configuré pour détecter une valeur de changement de courant depuis l'électrode source (300) et l'électrode drain (400), lorsqu'une valeur de courant s'écoulant sur la surface latérale du nanotube (100) est modifiée.

2. Dispositif à semi-conducteur pour mesurer une force de cisaillement selon la revendication 1, dans lequel le nanotube (100) est une structure cylindrique dans laquelle un diamètre diminue lorsqu'une distance par rapport au substrat (50) augmente.

3. Dispositif à semi-conducteur pour mesurer une force de cisaillement selon la revendication 1 ou 2, dans lequel le nanotube (100) présente un diamètre de 1 nm à 1000 nm, ou présente une épaisseur de 1 nm à 10 nm, ou présente une hauteur de 10 nm à 100 µm, et
dans lequel un rapport d'aspect du nanotube (100) est 1:1 à 1:1000.

4. Dispositif à semi-conducteur pour mesurer une force de cisaillement selon l'une quelconque des revendications 1 à 3, dans lequel l'au moins une électrode latérale (200) comprend une première électrode (210) et une seconde électrode (220) espacées l'une de l'autre,
la première électrode (210) détecte un changement de la répartition de charge dû à un premier composant de direction d'une force de cisaillement appliquée,
la seconde électrode (220) détecte un changement de répartition de charge dû à un second composant de direction de la force de cisaillement appliquée,
la première direction est parallèle ou antiparallèle à une direction depuis un centre du nanotube vers une région dans laquelle la première électrode (210) est agencée, et
la seconde direction est parallèle ou antiparallèle à une direction depuis le centre du nanotube vers une région dans laquelle la seconde électrode (220) est agencée.

5. Dispositif à semi-conducteur pour mesurer une force de cisaillement selon la revendication 4, dans lequel la première direction et la seconde direction sont perpendiculaires l'une à l'autre, et le dispositif à semi-conducteur est configuré pour décomposer en deux dimensions une direction de la force de cisaillement appliquée.

6. Dispositif à semi-conducteur pour mesurer une force de cisaillement selon l'une quelconque des revendications précédentes, dans lequel l'au moins une électrode latérale (200) est directement en contact avec le nanotube (100), et est configurée pour détecter une tension dans une zone en contact direct avec le nanotube (100).

7. Dispositif à semi-conducteur pour mesurer une force de cisaillement selon la revendication 1, dans lequel l'au moins une électrode latérale (200) comprend une électrode (210, 220) qui est en contact avec une zone du nanotube,
ladite une électrode est une électrode de grille pour mesurer un composant de direction de la force de cisaillement, et
ladite une direction est parallèle ou antiparallèle à une direction depuis un centre du nanotube vers ladite zone.

8. Dispositif à semi-conducteur pour mesurer une force de cisaillement selon la revendication 1, comprenant en outre un isolant (500) entre l'au moins un nanotube (100) et l'au moins une électrode latérale (200).

9. Capteur de force de cisaillement (A1) comprenant :
un dispositif à semi-conducteur (12, 13) selon l'une quelconque des revendications 1 à 8 ;
un processeur (20) pour calculer une force de cisaillement appliquée au dispositif à semi-conducteur à l'aide d'un changement de la répartition de charge détecté à travers l'au moins une électrode latérale.
